# EUROPÄISCHE PATENTSCHRIFT

(11) **EP 2 588 779 B1**
(45) Veröffentlichungstag und Bekanntmachung des Hinweises auf die Patenterteilung: **07.08.2019**
(21) Anmeldenummer: 11770325.6
(22) Anmeldetag: 28.06.2011
(51) Int. Cl.: F16H 61/00, H05K 5/00

(54) **SENSORTRÄGER SOWIE SENSORMODUL INSBESONDERE ZUM EINSATZ IN EINEM KRAFTFAHRZEUGVORORTSTEUERGERÄT**
SENSOR CARRIER AND SENSOR MODULE, IN PARTICULAR FOR USE IN AN ON-BOARD CONTROL UNIT FOR A MOTOR VEHICLE
SUPPORT DE CAPTEUR ET MODULE CAPTEUR, EN PARTICULIER À UTILISER DANS UN APPAREIL DE COMMANDE EMBARQUÉ DANS UN VÉHICULE AUTOMOBILE

(30) Priorität: 29.06.2010 DE 102010025591
(43) Veröffentlichungstag der Anmeldung: 08.05.2013
(73) Patentinhaber: CPT Zwei GmbH, 30165 Hannover (DE)
(72) Erfinder: WIECZOREK, Matthias, 91223 Neunkirchen am Sand (DE); KARRER, Helmut, 90762 Fürth (DE); VÖGERL, Andreas, 92331 Parsberg (DE); BUHL, Joachim, 90482 Nürnberg (DE); ALBERT, Andreas, 91315 Höchstadt/Aisch (DE); HENNINGER, Jürgen, 91056 Erlangen-Dechsendorf (DE)
(74) Vertreter: Bonn, Roman Klemens
(86) Internationale Anmeldenummer: PCT/DE2011/001413
(87) Internationale Veröffentlichungsnummer: WO 2012/013176

(56) Entgegenhaltungen:
- EP-A2- 1 239 710
- DE-A1-102006 059 741
- US-A1- 2008 108 478
- US-A1- 2009 122 501

## Beschreibung

Die Erfindung betrifft einen Sensorträger sowie ein Sensormodul insbesondere zum Einsatz in einem Kraftfahrzeugvorortsteuergerät nach den Oberbegriffen der unabhängigen Ansprüche.

Derartige Sensoranordnungen werden zunehmend in der Automobilindustrie eingesetzt. Der Einbauort ist beispielsweise ein Getriebe oder ein Motorraum eines Kraftfahrzeugs. Die Sensorelemente werden zur Ermittlung von Drehzahl, Gangstellerpositionen, Druck, oder anderen Messgrößen direkt in Steuergeräten verbaut. Dabei sind sie an dem Steuergerät entweder integriert oder als Sensormodul an das Steuergerät angebunden.

Die Sensoren benötigen dafür einen mechanischen Träger, der die Sensoren positioniert, fixiert und, der ausreichend stabil gegen Vibration ist. Des Weiteren wird eine elektrische Verbindung benötigt, um die Sensorsignale zur Steuereinheit weiterzuleiten.

Als Kontaktelement zur elektrischen Kontaktierung des Sensors mit der Steuereinheit kommt beispielsweise ein Stanzgitter zum Einsatz. Bei einer bevorzugten Ausführung werden die Stanzgitter mit einem Grundkörper ummantelt, was in der Regel durch ein zweistufiges Spritzverfahren geschieht. Derartige Sensoranordnungen werden Sensordome genannt. Eine andere Bauart ist die Verwendung flexibler Leiterfolie als elektrische Verbindung, die wiederum in Kunststoff Sensordomen eingelegt wird.

Die US 2008/108478 A1 beschreibt ein Steuermodul insbesondere für ein Getriebe eines Kraftfahrzeuges mit einem Trägerteil, wobei an dem Trägerteil ein Steuergerät mit einem zweiteiligen Gehäuse angeordnet ist, und wobei im Gehäuseinnenraum des zweiteiligen Gehäuses ein elektronisches Schaltungsteil angeordnet ist, und mit wenigstens einer flexiblen Leiterfolie zur elektrischen Verbindung des Schaltungsteils mit außerhalb des Gehäuseinnenraums angeordneten elektrischen Bauteilen, insbesondere Sensoren.

Die US 2009/122501 A1 beschreibt ein Steuergerät mit einem Gehäuse, umfassend einen Gehäusedeckel zur Aufnahme von Sensoren und eine Gehäuseschale zur Aufnahme mindestens einer Steuereinheit, mit mindestens einer Einrichtung zum elektrischen Verbinden der Sensoren mit der Steuereinheit, wobei die Einrichtung zum elektrischen Verbinden der Sensoren auf dem Gehäusedeckel mit der Steuereinheit in der Gehäuseschale als Folienleiter zwischen dem Gehäusedeckel und einem Dichtelement ausgebildet ist.

Der Nachteil an den bekannten Sensoranordnungen ist ihre aufwendige und kostenintensive Herstellung. Es werden komplizierte und teure Spritzgusswerkzeuge für Vorumspritzlinge und Hauptumspritzungen benötigt. Desweiteren benötigt man Stanz- und Biegewerkzeuge für Stanzgitter.

Es ist daher die Aufgabe der vorliegenden Erfindung, einen Sensorträger sowie ein Sensormodul insbesondere zum Einsatz in einem Kraftfahrzeugvorortsteuergerät zu schaffen, die einfacher und kostengünstiger herzustellen sind.

Diese Aufgabe ist erfindungsgemäß gelöst durch einen Sensorträger sowie ein Sensormodul mit den Merkmalen der unabhängigen Ansprüche 1 und 10.

Der erfindungsgemäße Sensorträger eines Steuergerätes umfasst eine als Stanzblech ausgeführte Trägerplatte, von der insbesondere ein streifenförmiger Ausleger wegführt, wobei ein Sensor am Ende des Auslegers angeordnet ist und der am Stanzblech ausgebildete Ausleger gebogen ist, um den Sensor mit dem Einbau des Steuergerätes in das Kraftfahrzeug an seiner bestimmungsgemäßen Sensierposition zu positionieren .

Diese Art von Sensorträger ist einfacher und günstiger in der Herstellung als ein üblicherweise verwendeter sogenannter Sensordom.

Vorteilhafterweise umfasst der Ausleger in Längsrichtung mindestens einen Abschnitt und die Abschnitte können sowohl untereinander als auch zur Trägerplatte beliebige Winkel bilden. Dadurch kann ein Sensor am Ende des Auslegers auch an schwierig zu erreichenden Sensierpositionen zum Einsatz kommen.

In manchen Fällen kann es auch erforderlich sein, dass auf einem Ausleger mehr als ein Sensor an geordnet ist.

Die Leiterfolie zur elektrischen Verbindung zwischen Sensor und Steuereinheit ist insbesondere zumindest teilweise auf der Trägerplatte auflaminiert oder aufgeklebt, wobei die Leiterfolie die Trägerplatte ganz oder nur teilweise bedeckt.

Als Spanschutz für die Kontaktierung zwischen Sensor und Leiterfolie ist vorteilhafterweise auf dem Ausleger ein Deckel angeordnet. Für den Fall, dass die Leiterfolie nicht auf der Trägerplatte auflaminiert oder aufgeklebt ist, sondern auf der Trägerplatte lediglich lose aufliegt, kann der Deckel darüber hinaus auch zur Fixierung der Leiterfolie auf der Trägerplatte dienen.
Insbesondere kann der Deckel aus Kunststoff bestehen und auf die Leiterfolie, den Ausleger gesamt oder nur teilweise umlaufend, auflaminiert sein. Alternativ kann der Deckel auch aus Aluminium sein, wodurch zusätzlich die EMV-Festigkeit erhöht wird.

In einer besonders einfachen Ausführungsform kann die Trägerplatte als Stanzblech ausgeführt sein. Dies hat den Vorteil, dass bei der Herstellung des Sensorträgers nach dem Aufbringen der Leiterfolie der Ausleger sogar in mehrere Raumrichtungen in Position gebogen werden kann und so den bestückten Sensor an die vorgesehene Sensierposition bringt. Durch zusätzliche Biegungen des Auslegers oder zusätzliche Strukturen im Blech kann insbesondere die Vibrationsfestigkeit des Sensorträgers erhöht werden.

Die Trägerplatte kann insbesondere mehr als einen streifenförmigen Ausleger aufweisen und bildet damit ein kompaktes Sensormodul.

In der nachfolgenden Beschreibung werden die Merkmale und Einzelheiten der Erfindung in Zusammenhang mit den beigefügten Zeichnungen anhand von Ausführungsbeispielen näher erläutert. In den Zeichnungen zeigen:
- Fig. 1: eine perspektivische Darstellung eines Sensorträgers mit mehreren Auslegern, und
- Fig. 2: einen Sensorträger wie in Fig. 1, um 180° gedreht.

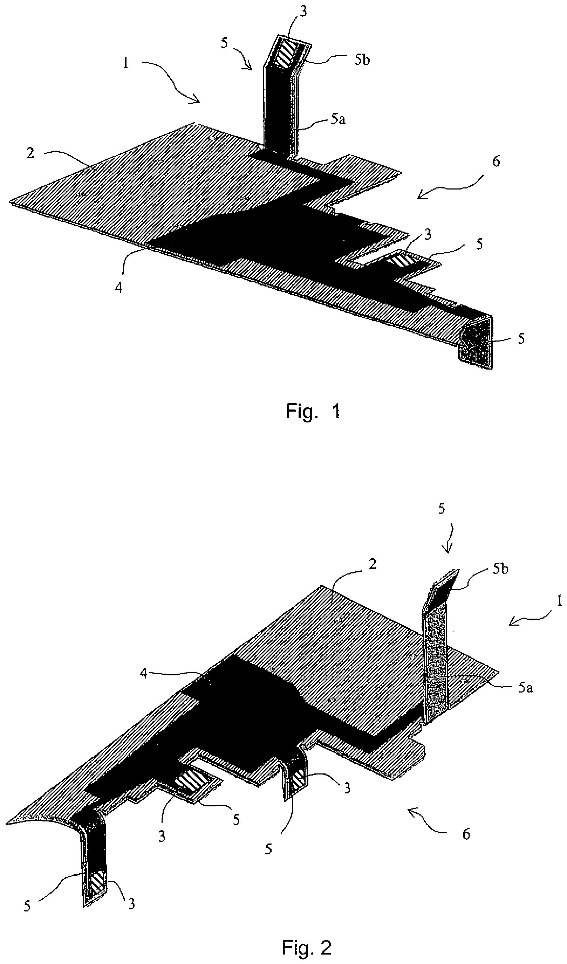

Fig. 1 zeigt ein Sensorträger 1 insbesondere zum Einsatz in einem Kraftfahrzeugvorortsteuergerät. Der Sensorträger 1 umfasst eine Trägerplatte 2 zur Aufnahme und Positionierung mindestens eines Sensors 3. Eine flexible Leiterfolie 4 als elektrische Verbindung zwischen dem Sensor 3 auf der Trägerplatte 2 und dem nicht gezeigten Steuergerät ist auf der Trägerplatte 2 angeordnet, insbesondere auflaminiert oder aufgeklebt. Die Form der Leiterfolie 4 entspricht in diesem Fall nicht der Form der Trägerplatte 2, die Trägerplatte 2 könnte aber auch ganzflächig von der Leiterfolie 4 bedeckt sein.

Von der Trägerplatte 2 führen streifenförmige Ausleger 5 weg. Dabei umfasst ein Ausleger 5 in Längsrichtung mindestens einen Abschnitt 5a, 5b und die Abschnitte 5a, 5b können sowohl untereinander als auch zur Trägerplatte 2 beliebige Winkel bilden. In der Regel bildet ein Ausleger 5 mit der Trägerplatte 2 einen Winkel von 0° oder 90°. Am Ende eines Auslegers 5 ist ein Sensor 3 angeordnet. Mit dem Einbau des Steuergerätes in das Kraftfahrzeug ist der Sensor dann vorteilhafterweise an seiner bestimmungsgemäßen Sensierposition positioniert.

Die flexible Leiterfolie 4 ist von der Trägerplatte 2 zum Ausleger 5 weitergeführt und dient als elektrische Verbindung zwischen dem Sensor 3 und dem nicht gezeigten Steuergerät. Auf einem Ausleger 5 könnten auch mehr als ein Sensor 3 an geordnet sein. Ferner können neben Sensoren 3 auch andere elektronische Bauelemente auf einem Ausleger 5 angebracht sein.

Die Trägerplatte 2 kann insbesondere aus Kunststoff oder Metall sein. In einer besonders einfachen Ausführungsform kann die Trägerplatte 2 als Stanzblech ausgeführt sein. Dies hat den Vorteil, dass bei der Herstellung des Sensorträgers 1 nach dem Aufbringen der Leiterfolie 4 der Ausleger 5 abschnittsweise in mehrere Raumrichtungen in Position gebogen werden kann und so den darauf angeordneten Sensor 3 sogar an einer schwer zugänglichen Sensierposition positionieren kann. Bei der Verwendung eines metallenen Stanz-Biegeteils fallen als Fertigungsschritte bei der Herstellung des Sensormoduls 1 im wesentlichen lediglich das Biegen des Stanzblechs und das Auflaminieren der Leiterfolie 4 an. Es werden keine komplizierten und teuren Spritzgusswerkzeuge für Vorumspritzlinge und Hauptumspritzungen wie bei der Herstellung von Sensordomen benötigt. Desweiteren benötigt man keine Stanz- und Biegewerkzeuge für Stanzgitter, wie sie beispielsweise in Sensordomen als elektrische Verbindung zwischen Sensor und Steuereinheit verwendet werden.

Das Sensormodul 1 kann im Steuergerät integriert oder am Steuergerät zum Beispiel kraft- oder formschlüssig angebunden sein.

## Patentansprüche

1. Sensorträger (1) insbesondere zum Einsatz in einem Kraftfahrzeugvorortsteuergerät, umfassend eine Trägerplatte (2) zur Aufnahme und Positionierung mindestens eines Sensors (3) und einer flexiblen Leiterfolie (4) auf der Trägerplatte (2) als elektrische Verbindung zwischen dem Sensor (3) auf der Trägerplatte (2) und dem Steuergerät, wobei von der Trägerplatte (2) ein streifenförmiger Ausleger (5) derart wegführt, dass der Sensor (3), der am Ende des Auslegers (5) angeordnet ist, mit dem Einbau des Steuer-gerätes in das Kraftfahrzeug an seiner bestimmungsgemäßen Sensierposition positioniert ist,
**dadurch gekennzeichnet, dass**,
die Trägerplatte (2) als Stanzblech ausgeführt ist, und dass der am Stanzblech ausgebildete Ausleger (5) gebogen ist, um den Sensor (3) an seine bestimmungsgemäße Sensierposition zu bringen.

2. Sensorträger (1) nach Anspruch 1, **dadurch gekennzeichnet, dass** der Ausleger (5) in Längsrichtung mindestens einen Abschnitt (5a, 5b) umfasst und die Abschnitte (5a, 5b) sowohl untereinander als auch zur Trägerplatte (2) beliebige Winkel bilden können.

3. Sensorträger (1) nach einem der vorhergehenden Ansprüche, **dadurch gekennzeichnet, dass** auf einem der Ausleger (5) mehr als ein Sensor (3) angeordnet ist.

4. Sensorträger (1) nach einem der vorhergehenden Ansprüche, **dadurch gekennzeichnet, dass** die Leiterfolie (4) zumindest teilweise auf der Trägerplatte (2) auflaminiert oder aufgeklebt ist.

5. Sensorträger (1) nach einem der vorhergehenden Ansprüche, **dadurch gekennzeichnet, dass** die Leiterfolie (4) die Trägerplatte (2) ganz oder nur teilweise bedeckt.

6. Sensorträger (1) nach einem der vorhergehenden Ansprüche, **dadurch gekennzeichnet, dass** auf dem Ausleger (5) ein Deckel angeordnet ist, wobei der Deckel insbesondere als Spanschutz für die Kontaktierung zwischen Sensor (3) und Leiterfolie (4) bzw. zur Fixierung der Leiterfolie (4) auf der Trägerplatte (2) dient.

7. Sensorträger (1) nach Anspruch 6, **dadurch gekennzeichnet, dass** der Deckel auf die Leiterfolie (4) auflaminiert ist.

8. Sensorträger (1) nach einem der vorhergehenden Ansprüche, **dadurch gekennzeichnet, dass** die Trägerplatte (2) als Stanzblech ausgeführt ist.

9. Sensorträger (1) nach einem der vorhergehenden Ansprüche, **dadurch gekennzeichnet, dass** der Ausleger (5) Strukturen aufweist, die seine Vibrationsfestigkeit erhöhen.

10. Sensormodul (6) insbesondere zum Einsatz in einem Kraftfahrzeugvorortsteuergerät, mit
einem Sensorträger (1) gemäß einem der Ansprüche 1 - 9, wobei die Trägerplatte (2) mehr als einen streifenförmigen Ausleger (5) aufweist.

## Claims

1. Sensor carrier (1), in particular for use in a motor vehicle in-situ control device, comprising a carrier plate (2) for accommodating and positioning at least one sensor (3) and a flexible conductor foil (4) on the carrier plate (2) as an electrical connection between the sensor (3) on the carrier plate (2) and on the control device, wherein a strip-shaped extension (5) leads away from the carrier plate (2) in such a way that when the control device is installed in the motor vehicle the sensor (3) which is arranged at the end of the extension (5) is positioned at its correct sensing position,
**characterized in that**
the carrier plate (2) is embodied as a piece of stamped sheet metal, and **in that** the extension (5) which is formed on the piece of stamped sheet metal is bent in order to move the sensor (3) to its correct sensing position.

2. Sensor carrier (1) according to Claim 1, **characterized in that** the extension (5) comprises at least one section (5a, 5b) in the longitudinal direction, and the sections (5a, 5b) can form any desired angles with one another and with respect to the carrier plate (2).

3. Sensor carrier (1) according to one of the preceding claims, **characterized in that** more than one sensor (3) is arranged on one of the extensions (5).

4. Sensor carrier (1) according to one of the preceding claims, **characterized in that** the conductor foil (4) is laminated or bonded at least partially on the carrier plate (2).

5. Sensor carrier (1) according to one of the preceding claims, **characterized in that** the conductor foil (4) covers the carrier plate (2) entirely or only partially.

6. Sensor carrier (1) according to one of the preceding claims, **characterized in that** a cover is arranged on the extension (5), wherein the cover serves, in particular, as a chip guard for the formation of contact between the sensor (3) and the conductor foil (4) and/or for securing the conductor foil (4) on the carrier plate (2).

7. Sensor carrier (1) according to Claim 6, **characterized in that** the cover is laminated onto the conductor foil (4).

8. Sensor carrier (1) according to one of the preceding claims, **characterized in that** the carrier plate (2) is embodied as a piece of stamped sheet metal.

9. Sensor carrier (1) according to one of the preceding claims, **characterized in that** the extension (5) has structures which increase its resistance to vibration.

10. Sensor module (6), in particular for use in a motor vehicle in-situ control device, having
a sensor carrier (1) according to one of Claims 1 - 9, wherein the carrier plate (2) has more than one strip-shaped extension (5).

## Revendications

1. Support de capteur (1), en particulier destiné à être utilisé dans un appareil de commande embarqué dans un véhicule automobile, comprenant une plaque support (2) destinée à recevoir et à positionner au moins un capteur (3) et une feuille conductrice (4) flexible sur la plaque support (2) en tant que connexion électrique entre le capteur (3) sur la plaque support (2) et l'appareil de commande, une console (5) en forme de ruban partant de la plaque support (2) de telle sorte que le capteur (3), qui est disposé à l'extrémité de la console (5), est positionné dans sa position de détection appropriée lors du montage de l'appareil de commande dans le véhicule automobile,
**caractérisé en ce que**
la plaque support (2) est réalisée en tant que tôle estampée, et **en ce que** la console (5) constituée sur la tôle estampée est courbée pour conduire le capteur (3) à sa position de détection appropriée.

2. Support de capteur (1) selon la revendication 1,
**caractérisé en ce que**, dans la direction longitudinale, la console (5) comprend au moins un tronçon (5a, 5b), et les tronçons (5a, 5b) peuvent former des angles quelconques les uns par rapport aux autres ainsi que par rapport à la plaque support (2).

3. Support de capteur (1) selon l'une des revendications précédentes, **caractérisé en ce que** plus d'un capteur (3) est disposé sur l'une des consoles (5).

4. Support de capteur (1) selon l'une des revendications précédentes, **caractérisé en ce que** la feuille conductrice (4) est laminée ou collée au moins partiellement sur la plaque support (2).

5. Support de capteur (1) selon l'une des revendications précédentes, **caractérisé en ce que** la feuille conductrice (4) recouvre la plaque support (2) totalement ou seulement en partie.

6. Support de capteur (1) selon l'une des revendications précédentes, **caractérisé en ce qu'**un couvercle est disposé sur la console (5), le couvercle servant en particulier de protection contre les limailles pour la réalisation du contact entre le capteur (3) et la feuille conductrice (4) ou respectivement pour la fixation de la feuille conductrice (4) sur la plaque support (2).

7. Support de capteur (1) selon la revendication 6, **caractérisé en ce que** le couvercle est laminé sur la feuille conductrice (4).

8. Support de capteur (1) selon l'une des revendications précédentes, **caractérisé en ce que** la plaque support (2) est réalisée en tant que tôle estampée.

9. Support de capteur (1) selon l'une des revendications précédentes, **caractérisé en ce que** la console (5) comporte des structures qui augmentent sa résistance aux vibrations.

10. Module de capteur (6), en particulier destiné à être utilisé dans un appareil de commande embarqué dans un véhicule automobile, avec
un support de capteur (1) selon l'une des revendications 1 - 9, la plaque support (2) comportant plus d'une console (5) en forme de ruban.
